# EUROPÄISCHE PATENTSCHRIFT

(11) **EP 0 711 106 B1**
(45) Veröffentlichungstag und Bekanntmachung des Hinweises auf die Patenterteilung: **02.02.2000**
(21) Anmeldenummer: 95117233.7
(22) Anmeldetag: 02.11.1995
(51) Int. Cl.: H05K 3/40

(54) **Verfahren zum Durchkontaktieren von Bohrungen in mehrlagigen Leiterplatten**
Process for making through-hole connections in multilayer printed circuit boards
Procédé pour établir des connexions à trous traversants dans des panneaux à circuit imprimé multicouches

(30) Priorität: 02.11.1994 DE 4439108
(43) Veröffentlichungstag der Anmeldung: 08.05.1996
(73) Patentinhaber: LPKF Laser & Electronics AG, D-30827 Garbsen/OT Berenbostel (DE)
(72) Erfinder: Wenke, Stephan, D-30823 Garbsen (DE)
(74) Vertreter: Braun, Dieter, Dipl.-Ing.

(56) Entgegenhaltungen:
- EP-A- 0 147 901
- EP-A- 0 194 247
- DE-A- 3 214 097
- GB-A- 2 246 912
- PATENT ABSTRACTS OF JAPAN vol. 15 no. 110 (E-1046) ,15.März 1991 & JP-A-03 003392 (JUKI CORP.) 9.Januar 1991,
- PATENT ABSTRACTS OF JAPAN vol. 13 no. 184 (E-751) ,28.April 1989 & JP-A-01 010697 (JUKI CORP.) 13.Januar 1989,

## Beschreibung

Die Erfindung betrifft ein Verfahren zum Durchkontaktieren von Bohrungen in mehrlagigen Leiterplatten, wobei die Leiterplatte auf einen Aufnahmerahmen aufgelegt wird, der den Bereich unterhalb der Bohrungen frei läßt und Leitpaste unter Ausbildung von Randbedeckungen in die Bohrungen der Leiterplatte mittels einer Dosiereinrichtung so eingebracht wird, daß sich an der Rückseite der Bohrungen ein überstehender, sich aufweitender Zapfen ausbildet.

Durch die DE 35 09 626 A1 ist es bereits bekannt geworden, zum Durchkontaktieren von Leiterplatten auf die Bohrungen der Leiterplatten Leitpaste mittels eines Siebdruckverfahrens aufzubringen und die Leitpaste mittels Unterdrucks, die an eine unterhalb der Leiterplatte vorgesehene Unterdruckzufuhr gelegt ist, teilweise in die Bohrungen zu ziehen, wobei vermieden wird, daß die Leitpaste auch an die Unterseite der Bohrungen gelangt. Anschließend müssen die Leiterplatten mit ihrer Unterseite nach oben in die Vorrichtung eingelegt werden, und der beschriebene Vorgang des Einbringens von Leitpaste in die Bohrungen der Leiterplatte wiederholt sich. Hierdurch wird zwar eine Durchkontaktierung erreicht, nachteilig ist es jedoch, daß die Leiterplatte stets ein zweites Mal in die Vorrichtung eingelegt werden muß und daß im Bereich der Bohrungen und im Bereich der Randbedeckungen ein unterschiedlich dicker und insgesamt relativ dicker Auftrag von Leitpaste erfolgt. Die Bohrungen sind im übrigen nach der Kontaktierung in ihren Durchmessern nicht exakt definiert.

Gemäß der EP 0 194 247 A2 wurde auch bereits vorgeschlagen, zur Durchkontaktierung von Leiterplatten Leitpaste mittels eines Siebdruckverfahrens unter Ausbildung von Randbedeckungen aufzubringen und dann mittels Saugluft in die Bohrungen der Leiterplatten so einzubringen, daß die Leitpaste rückseitig austritt. Anschließend wird mittels Druckluft unter Ausbildung von Randbedeckungen auf der Rückseite, die Leitpaste partiell entfernt, wobei auch an den Wandungen der Bohrungen leitfähige Leitpaste verbleibt. Dieses Verfahren erfordert jedoch eine aufwendige Druckmaschine. Außerdem sind für jede Leiterplattenstruktur eine Schablone sowie eine entsprechende Unterlage anzufertigen. Dieses Verfahren ist daher nur in einer Serienfertigung wirtschaftlich.

Durch die US 5 145 691 ist es auch bereits bekannt geworden, die Bohrungen von Leiterplatten mittels einer Dosiervorrichtung zum Zwecke der Durchkontaktierung mit Leitpaste zu füllen. Die eingebrachte Leitpaste verbleibt dann in der Bohrung und füllt diese vollständig aus. Zusätzlich ist es hier erforderlich, auf die Leiterplatte eine Maske aufzulegen.

Der Erfindung liegt die Aufgabe zugrunde, in der Prototypen und Kleinserienfertigung doppelseitiger Leiterplatten die Durchkontaktierung von Leiterplatten sehr flexibel unter direkter Auswertung elektronisch erfaßter Steuerdaten vornehmen zu können, wobei beidseitig der Bohrungen exakt begrenzte dünne Randbedeckungen geschaffen werden und gleichzeitig eine Ablagerung von Leitpaste in dünnen Schichten an den Wandungen der Bohrungen erzielbar ist, woraus sich definierte Mindestdurchmesser der Bohrungen ergeben, die ein Einstecken und Einlöten der Kontakte elektronischer Bauelemente ermöglichen.

Erfindungsgemäß wird diese Aufgabe durch die Merkmale des Anspruchs 1 und des Anspruchs 6 gelöst. Die weitere Ausgestaltung der Erfindung ist den Unteransprüchen zu entnehmen.

Dadurch, daß auf die Leiterplatte im Bereich jeder zu kontaktierenden Bohrung eine Kartuschennadel der Dosiereinrichtung aufgesetzt und lötfähige Leitpaste eingebracht wird, daß die Kartuschennadel entfernt und auf die Leiterplatte im Bereich der Bohrung ein Vakuumstift der Dosiereinrichtung aufgesetzt und die Leitpaste teilweise abgesaugt wird, wird erreicht, daß die Leitpaste im Bereich der Bohrungen beidseitig der Leiterplatte kontaktierende Randbedeckungen ausbildet und eine Verteilung der Leitpaste an den Innenwandungen der Bohrungen unter Ausbildung definierter Mindest-Lochdurchmesser erfolgt. Die Ausbildung der Randbedeckungen an der Rückseite der Bohrungen wird dabei dadurch begünstigt, daß die den Zapfen bildende Leitpaste sich nach dem Austritt aus der Bohrung entspannt und so eine Verbreiterung des Zapfens über den Durchmesser der Bohrungen hinaus eintritt. Unter dem Einfluß der sich anschließenden entgegengesetzt gerichteten Saugluftbeaufschlagung wird die Leitpaste in die Bohrungen zurückgezogen, wobei es zu einem Abstreifen von Leitpaste am rückseitigen Austritt der Bohrungen und einer Ausbildung von Randbedeckungen kommt. Durch die Saugluftbeaufschlagung wird zudem erreicht, daß die Leitpaste aus dem Bereich der Bohrungen der Leiterplatte weitgehend entfernt wird und daß an den Wandungen der Bohrungen nur eine relativ dünne leitfähige Schicht Leitpaste haften bleibt, deren Stärke durch die intensität der Saugluftbeaufschlagung, d. h. durch den zeitlichen Druckverlauf einstellbar ist. Es können so genau definierte Durchmesser der kontaktierten Bohrungen erzeugt werden, die später ein Einstecken und Einlöten der Kontakte von elektronischen Bauteilen ermöglichen.

Vorzugsweise sind die Kartuschennadel und der Vakuumstift einem Fräsbohrkopf zugeordnet, wobei das Durchkontaktieren der Bohrungen direkt anschließend an die mechanische Bearbeitung der Leiterplatte erfolgt. Außerdem ist es gemäß einer bevorzugten Ausführungsform vorgesehen, daß die Funktion und die Arbeitsbewegung des Fräsbohrkopfes von einem Rechner gesteuert werden und daß zur Durchkontaktierung eine Druck-Saugluftbeaufschlagung der Kartuschennadel und des Vakuumstiftes von einem Steuergerät in Abhängigkeit von der jeweiligen Position des Fräsbohrkopfes und den Vorgaben des Rechners gesteuert wird. Es ergibt sich so der erhebliche Vorteil. daß die Durchkontaktierung von Leiterplatten sehr flexibel unter direkter Auswertung elektronisch erfaßter Steuerdaten erfolgt. Es entfällt die aufwendige Erstellung von Siebdruckschablonen und die Dosierung der Leitpaste ist exakt steuerbar und an die jeweiligen Erfordernisse jeweils sofort anpaßbar.

Im Rahmen der Erfindung ist es weiterhin vorgesehen, daß nach dem Einbringen der Leitpaste in eine Bohrung an der Kartuschennadel leichtes Vakuum anliegt, da so sicher verhindert wird, daß keine weitere Leitpaste unkontrolliert aus der Kartuschennadel austritt.

Gemäß einer bevorzugten Ausgestaltung des Verfahrens wird der Vakuumstift bereits während der Annäherung an die jeweils zu kontaktierende Bohrung der Leiterplatte, d. h. vor dem Aufsetzen, mit Saugluft beaufschlagt ist, derart, daß die Einwirkung der Saugluft sehr sanft dosiert einsetzt. So wird noch präziser ermöglicht, die Bohrungen der Leiterplatte sehr dünnschichtig unter Ausbildung genau definierter Lochdurchmesser zu kontaktieren.

Erfindungsgemäß wird eine lötfähige Leitpaste verwendet, so daß in die Bohrungen nach erfolgter Durchkontaktierung und nach dem Aushärten der Leitpaste die Kontakte elektronischer Bauelemente eingelötet werden können.

Die im Rahmen der Erfindung vorzugsweise eingesetzte Vorrichtung ist dadurch gekennzeichnet, daß eine Aufnahmevorrichtung mit einem Aufnahmerahmen für die Leiterplatte und eine Dosiereinrichtung mit einer Kartuschennadel vorgesehen ist, die über den Bohrungen positioniert und auf die Leiterplatte aufgesetzt werden kann und mittels der die lötfähige Leitpaste dann in die Bohrungen eingebracht wird, sowie daß die Dosiereinrichtung außerdem einen Vakuumstift aufweist, der nach dem Einbringen der Leitpaste im Bereich der Bohrungen positioniert aufgesetzt werden kann und über den die Leitpaste mittels dosiert gesteuerter Saugluft zum Teil wieder abgesaugt wird.

Eine weitere bevorzugt eingesetzte Vorrichtung weist das Merkmal auf, daß die Kartuschennadel und der Vakuumstift der Dosiereinrichtung an einem Fräsbohrkopf zur mechanischen Bearbeitung der Leiterplatte befestigt sind, so daß die mechanische Bearbeitung der Leiterplatte und das Durchkontaktieren der Bohrungen mittels einer einzigen Vorrichtung erfolgen kann.

Vorzugsweise sind außerdem ein Rechner und ein Steuergerät angeordnet, wobei über den Rechner die Funktion und die Arbeitsbewegung des Fräsbohrkopfes und von dem Steuergerät zur Durchkontakttierung eine Druck- Saugluftbeaufschlagung der Kartuschennadel und des Vakuumstiftes in Abhängigkeit von der jeweiligen Position des Fräsbohrkopfes und den Vorgaben des Rechners gesteuert werden. Es ergibt sich so der erhebliche Vorteil. daß die Durchkontaktierung von Leiterplatten sehr flexibel unter direkter Auswertung elektronisch erfaßter Steuerdaten erfolgt. Es entfällt die aufwendige Erstellung von Siebdruckschablonen und Unterlageplatten. Die Dosierung der Leitpaste ist exakt steuerbar und an die jeweiligen Erfordernisse jeweils sofort anpaßbar.

Zur optimalen Ausbildung der von der Leitpaste gebildeten kontaktierenden Randbedeckungen im Bereich der Ränder der Bohrungen beidseitig der Leiterplatte, hat es sich als vorteilhaft herausgestellt, wenn der Innendurchmesser der Kartuschennadel in ihrem Austriitsbereich wenigstens 0,2 mm größer ist, als der Durchmesser der jeweils zu kontaktierenden Bohrungen der Leiterplatte, derart, daß in diesem Bereich die kontaktierenden Randbedeckungen an der Oberseite der Leiterplatte ausgebildet werden können. Im Rahmen der Erfindung ist es außerdem vorgesehen, daß der Innendurchmesser des Vakuumstiftes des Dispensers größer ist, als der Innendurchmesser der Kartuschennadel.

In der Zeichnung ist ein Ausführungsbeispiel der Erfindung dargestellt und wird im folgenden näher beschrieben. Es zeigen:
Figur 1, eine Leiterplatte, die zum Durchkontaktieren in einer mit einem Dispenser versehenen Aufnahmevorrichtung angeordnet ist, vor dem Einbringen der Leitpaste;
Figur 2, die Leiterplatte gemäß Figur 1, nach dem Einbringen der Leitpaste;
Figur 3, die Leiterplatte gemäß Figur 1, nach dem Absaugen der Leitpaste;
Figur 4, eine Vorrichtung zum Durchkontaktieren in schematischer Darstellung.

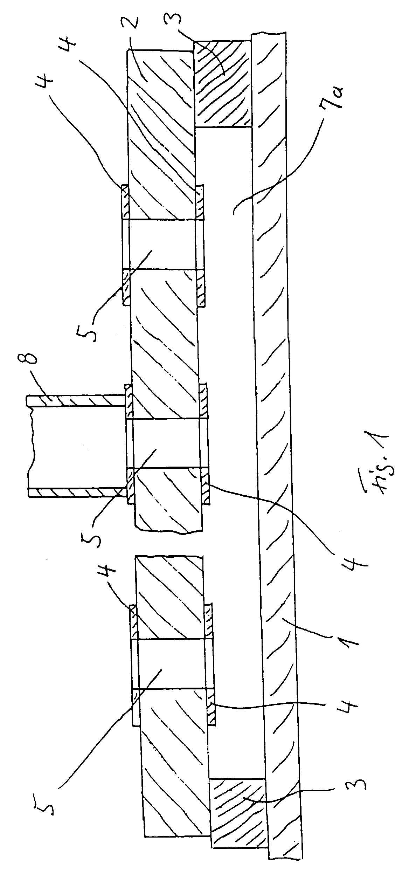

In der Zeichnung ist mit 1 eine Aufnahmevorrichtung bezeichnet, die als Auflagetisch ausgebildet ist. Auf der Aufnahmevorrichtung 1 ist eine durchzukontaktierende Leiterplatte 2 angeordnet, wobei, wie aus den Figuren 1 bis 3 ersichtlich, zwischen der Leiterplatte 2 und der Aufnahmevorrichtung 1 ein offener Aufnahmerahmen 3 angeordnet ist. Der Aufnahmerahmen 3 ist im übrigen beispielsweise aus Hartpapier hergestellt und etwa 2 bis 3 mm dick. Die Leiterplatte 2 ist an ihrer Ober- und Unterseite im Bereich von Bohrungen 5 mit Pads 4 versehen, die von elektrisch leitfähigen Schichten, vorzugsweise Kupferschichten, gebildet sind und Anschlußpunkte von Leiterbahnen und/oder elektronischen Bauteilen darstellen. In den den Figuren 1 bis 3 der Zeichnung sind im übrigen in stark vergrößerten Abbildungen jeweils nur Ausschnitte der Leiterplatte 2 dargestellt.

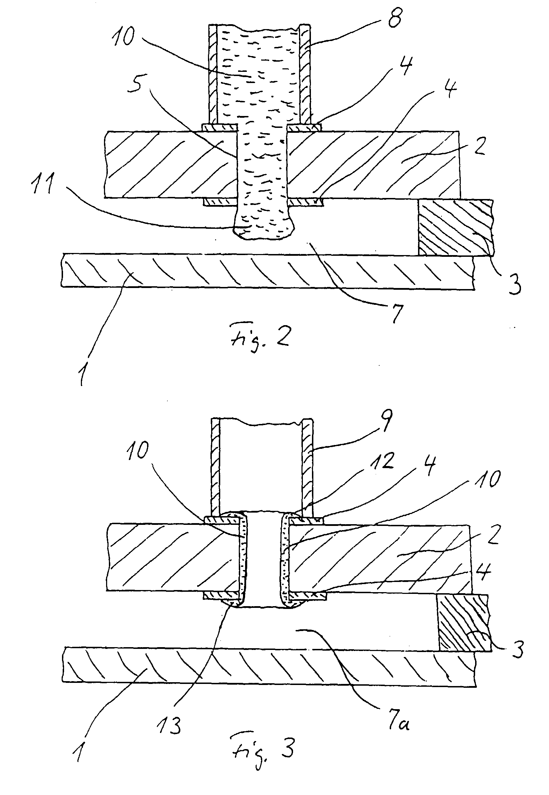

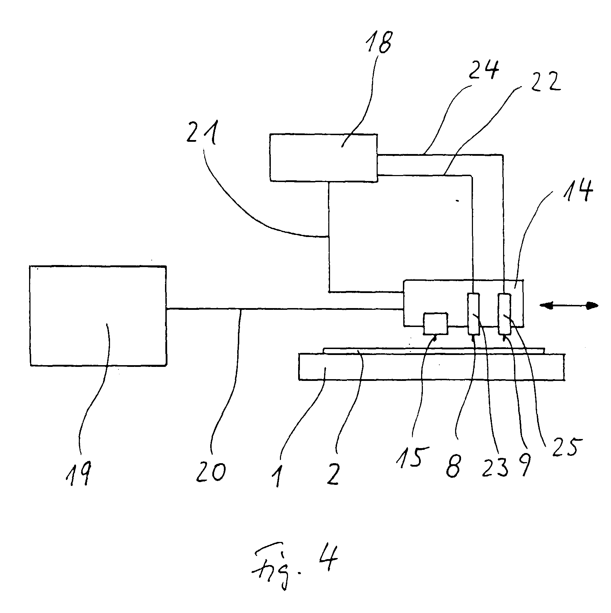

In der Figur 4 der Zeichnung ist eine Vorrichtung mit einem parallel zu der durchzukontaktierenden Leiterplatte 2 verfahrbaren Fräsbohrkopf 14 dargestellt. Dessen Verfahrbewegung ist von einem Rechner 19 steuerbar, der über Steuerleitungen 20 mit in der Zeichnung nicht dargestellten Antriebsmotoren des Fräsbohrkopfes 14 verbunden ist. Der Fräsbohrkopf 14 ist über Steuerleitungen 21 an ein Steuergerät 18 zur Druckluft- und Saugluftdosierung angeschlossen. Vom Steuergerät 18 ist eine Zuleitung 22 an eine am Fräsbohrkopf 14 angeordnete Kartusche 23 mit einer Kartuschennadel 8 zum Einbringen von lötfähiger Leitpaste in die Bohrungen 5 der Leiterplatte 2 geführt. Eine Saugluftleitung 24 ist außerdem vom Steuergerät 18 an eine am Fräsbohrkopf 14 angeordnete Kartusche 23 mit einem Vakuumstift 9 zum Absaugen von überschüssiger Leitpaste aus den Bohrungen 5 der Leiterplatte 2 geführt. Im Fräsbohrkopf 14 ist außerdem ein Bohrer 15 angeordnet, der auch durch einen Fräser ersetzt werden kann. Mittels des Bohrers 15 werden die Bohrungen 5 in die Leiterplatte 2 eingebracht, bzw. wird mittels des Fräsers die Leiterplatte 2 strukturiert.

Wie aus der Figur 1 ersichtlich, liegt bei dem dort dargestellten Ausführungsbeispiel auf der Oberseite der Leiterplatte 2, d. h. auf dem dort angeordneten Pad 4, die Kartuschennadel 8 dichtend auf. Vorausgegangen war das Einbringen der Bohrung 5 mittels des Bohrers 15 des Fräsbohrkopfes 14.

Wie in der Figur 2 dargestellt, wird zum Durchkontaktieren der Leiterplatte 2 über die Kartuschennadel 8 lötfähige Leitpaste 10 in die Bohrungen 5 der Leiterplatte 2 dosiert eingebracht. Der Kartuschennadel 8 und wird Leitpaste 10 aus der der in der Figur 4 dargestellten Kartusche 23 zugeführt. Hierzu erfolgt eine Druckluftbeaufschlagung Kartusche 23 über die Zuleitung 22, die vom Steuergerät 18 in Abhängigkeit von der jeweiligen Position des Fräsbohrkopfes 14 und den Vorgaben des Rechners 19 gesteuert ist. Beim Einbringen mittels der Kartuschennadel 8 tritt die Leitpaste 10 rückseitig der Leiterplatte 2 aus den Bohrungen 5, einen Zapfen 11 bildend aus. Der Aufnahmerahmen 3 weist im Bereich der Bohrungen 5 der Leiterplatte 2 eine großflächige Ausnehmung 7a auf und ist auch seitlich offen, so daß die Ausnehmung 7a mit Atmosphärendruck beaufschlagt ist.

Nach dem dosierten Einbringen der Leitpaste 10 in die Bohrungen 5 der Leiterplatte 2 wird über das Steuergerät 18 an die Kartusche 23 und die Kartuschennadel 8 ein leichter Unterdruck angelegt, so daß keine weitere Leitpaste 10 austreten kann. Die Kartuschennadel 8 wird dann von der Leiterplatte 2 entfernt. Es wird dann, wie aus der Figur 3 ersichtlich, der Vakuumstift 9 im Bereich jeder zu kontaktierenden Bohrung 5 auf die Leiterplatte 2 aufgesetzt. Durch eine Saugluftbeaufschlagung der in der Figur 4 dargestellten Kartusche 25 und damit auch des Vakuumstiftes 9 über die Saugluftleitung 24 wird aus der Bohrung 5 überschüssige Leitpaste 10 in die Kartusche 25 abgesaugt. Dabei wird die Saugluft vom Steuergerät 18, das in Abhängigkeit von der jeweiligen Position des Fräsbohrkopfes 14 und der Vorgaben des Rechners 19 gesteuert ist, in die Saugluftleitung 24 eingebracht.

Vorzugsweise ist der Vakuumstift 9 bereits während seiner Annäherung an die Leiterplatte 2, d. h. an die jeweils zu kontaktierende Bohrung 5 der Leiterplatte 2, mit Saugluft beaufschlagt, wodurch die Einwirkung der Saugluft sehr sanft dosiert einsetzt. Wie sich gezeigt hat, ist insbesondere dann die Ausbildung einer dünnen Schicht von Leitpaste 10 an den Innenwandungen der Bohrungen 5 erreichbar. Es erfolgt eine vollflächige Verteilung der Leitpaste 10 unter Ausbildung sehr exakt definierter Mindest-Lochdurchmesser. Außerdem werden beidseitig der Leiterplatte 2 an den Pads 4 kontaktierende dünnschichtige Randbedeckungen 12 und 13 ausgebildet. Die Ausbildung der Randbedeckungen 13 der Pads 4 an der Unterseite der Leiterplatte 2 wird dadurch begünstigt, daß die die Zapfen 11 bildende Leitpaste 10 sich nach dem Austritt aus den Bohrungen 5 entspannt und so eine Verbreiterung der Zapfen 11 über den Durchmesser der Bohrungen 5 hinaus eintritt. Wird dann die Leitpaste 10 in die Bohrungen 5 dosiert gesteuert zurückgesaugt, so kommt es zu einem Abstreifen der Leitpaste an den unterseitigen Rändern der Bohrungen 5 und einer Kontaktierung der Pads 4 der Leiterplatte 2. Schließlich verbleibt an der Unterseite der Leiterplatte 2 eine die Pads 4 kontaktierende dünnschichtige Randbedeckung 13, die eine sichere, elektrisch leitfähige Verbindung herstellt.

Über die Intensität der Saugluftbeaufschlagung ist die Menge der an den Wandungen der Bohrungen 5 verbleibenden Leitpaste 10 einstellbar. Es sind somit definierte durchkontaktierte Mindest-Lochdurchmesser herstellbar, in die später Kontakte elektronischer Bauteile eingesteckt und eingelötet werden können. Hierbei ist es von Bedeutung, daß eine spezielle lötfähige Leitpaste 10 eingesetzt wird, die ein Einlöten der Kontakte ermöglicht. Die herkömmlichen silberhaltigen Leitpasten bilden nach dem Auftragen bekanntlich an ihrer Oberfläche eine nicht lötfähige Sperrschicht aus, da das Silber von der Oberfläche weg in die Paste hinein diffundiert. Aus diesem Grunde ist bei diesen Leitpasten nachträglich auch keine elektrisch leitende Verbindung durch das Verzinnen beim Lötvorgang herstellbar.

Wie aus der Figur 3 der Zeichnung ersichtlich ist, bildet sich nach dem Absaugen der leitpaste 10 auch an der Oberseite der Leiterplatte 2 innerhalb des Vakuumstiftes 9 eine Randbedeckung 12 aus. Auch hier verbleibt von der Kartuschennadel 8 aufgebrachte Leitpaste 10 auf dem frei liegenden Bereich des Pads 4 und stellt auch dort eine elektrisch sichere Verbindung her. Der Durchmesser der an der Oberseite der Leiterplatte 2 verbleibenden Randbedeckungen 12 wird letztlich vom Innendurchmesser des dichtend aufliegenden Vakuumstiftes 9 bestimmt. Dieser Innendurchmesser sollte stets größer sein, als der Innendurchmesser der Kartuschennadel 8.

Nachdem der Vorgang der Durchkontaktierung mit Hilfe der Leitpaste 10 beendet ist, muß die Leitpaste in einem Ofen bei ca. 160 °C ca. 30 Minuten lang aushärten. Danach kann die Leiterplatte 2 gegebenenfalls mit den Kontakten elektronischer Bauteile bestückt und verlötet werden.

## Patentansprüche

1. Verfahren zum Durchkontaktieren von Bohrungen (5) in mehrlagigen Leiterplatten (2), wobei die Leiterplatte (2) auf einen Aufnahmerahmen (3) aufgelegt wird, der den Bereich unterhalb der Bohrungen (5) frei läßt und Leitpaste (10) unter Ausbildung von Randbedeckungen (12) in die Bohrungen (5) der Leiterplatte (2) mittels einer Dosiereinrichtung (8, 9) so eingebracht wird, daß sich an der Rückseite der Bohrungen (5) ein überstehender, sich aufweitender Zapfen (11) ausbildet, dadurch gekennzeichnet, daß auf die Leiterplatte (2) im Bereich jeder zu kontaktierenden Bohrung (5) eine Kartuschennadel (8) der Dosiereinrichtung (8, 9) aufgesetzt und lötfähige Leitpaste (10) eingebracht wird, daß die Kartuschennadel (8) entfernt und auf die Leiterplatte (2) im Bereich der Bohrung (5) ein Vakuumstift (9) der Dosiereinrichtung (8, 9) aufgesetzt und die Leitpaste (10) teilweise abgesaugt wird, derart, daß die Leitpaste (10) im Bereich der Bohrungen (5) beidseitig der Leiterplatte (2) kontaktierende Randbedeckungen (12, 13) ausbildet und eine Verteilung der Leitpaste (10) an den Innenwandungen der Bohrungen (5) unter Ausbildung definierter Mindest-Lochdurchmesser erfolgt.

2. Verfahren nach Anspruch 1, dadurch gekennzeichnet, daß die Kartuschennadel (8) und der Vakuumstift (9) einem Fräsbohrkopf (14), zugeordnet sind und daß das Durchkontaktieren der Bohrungen (5) direkt anschließend an die mechanischen Bearbeitung der Leiterplatte (2) mittels einer einzigen Vorrichtung (Fräsbohrkopf 14) erfolgt.

3. Verfahren nach den Ansprüchen 1 und 2, dadurch gekennzeichnet, daß die Funktion und die Arbeitsbewegung des Fräsbohrkopfes (14) von einem Rechner (19) und zur Durchkontakttierung eine Druck- Saugluftbeaufschlagung der Kartuschennadel (8) und des Vakuumstiftes (9) von einem Steuergerät (18) in Abhängigkeit von der jeweiligen Position des Fräsbohrkopfes (14) und den Vorgaben des Rechners (19) gesteuert werden.

4. Verfahren nach einem oder mehreren der Ansprüche 1 bis 3, dadurch gekennzeichnet, daß nach dem Einbringen der Leitpaste (10) in eine Bohrung (5) an der Kartuschennadel (8) leichtes Vakuum anliegt, derart, daß keine weitere Leitpaste (10) austritt.

5. Verfahren nach einem oder mehreren der Ansprüche 1 bis 4, dadurch gekennzeichnet, daß der Vakuumstift (9) bereits während der Annäherung an die jeweils zu kontaktierende Bohrung (5) der Leiterplatte (2), d. h. vor dem Aufsetzen, mit Saugluft beaufschlagt ist, derart, daß die Einwirkung der Saugluft sehr sanft dosiert einsetzt.

6. Vorrichtung für ein Verfahren nach Anspruch 1, dadurch gekennzeichnet, daß eine Aufnahmevorrichtung (1) mit einem Aufnahmerahmen (3) für die Leiterplatte (2) und eine Dosiereinrichtung (8, 9) mit einer Kartuschennadel (8) vorgesehen ist, die über den Bohrungen (5) positioniert und auf die Leiterplatte (2) aufgesetzt werden kann und mittels der die lötfähige Leitpaste (10) dann in die Bohrungen (5) eingebracht wird, sowie daß die Dosiereinrichtung (8, 9) außerdem einen Vakuumstift (9) aufweist, der nach dem Einbringen der Leitpaste (10) im Bereich der Bohrungen (5) aufgesetzt werden kann und über den die Leitpaste (10) mittels dosiert gesteuerter Saugluft zum Teil wieder abgesaugt wird.

7. Vorrichtung nach Anspruch 6, dadurch gekennzeichnet, daß daß die Kartuschennadel (8) und der Vakuumstift (9) der Dosiereinrichtung (8, 9) an einem Fräsbohrkopf (14) angeordnet sind, derart, daß mechanischen Bearbeitung der Leiterplatte (2) und das Durchkontaktieren der Bohrungen (5) mittels einer einzigen Vorrichtung (Fräsbohrkopf 14) erfolgt.

8. Vorrichtung nach den Ansprüchen 6 und 7, dadurch gekennzeichnet, daß ein Rechner (19) und ein Steuergerät (14) angeordnet sind, wobei über den Rechner (19) die Funktion und die Arbeitsbewegung des Fräsbohrkopfes (14) und von dem Steuergerät (14) zur Durchkontakttierung eine Druck- Saugluftbeaufschlagung der Kartuschennadel (8) und des Vakuumstiftes (9) in Abhängigkeit von der jeweiligen Position des Fräsbohrkopfes (14) und den Vorgaben des Rechners (19) gesteuert werden.

9. Vorrichtung nach einem oder mehreren der Ansprüche 6 bis 8, dadurch gekennzeichnet, daß der Innendurchmesser der Kartuschennadel (8) in ihrem Austrittsbereich wenigstens 0,2 mm größer ist, als der Durchmesser der Bohrungen (5) der Leiterplatte (2), derart, daß in diesem Bereich die kontaktierenden Randbedeckungen (12) an der Oberseite der Leiterplatte (2) ausgebildet werden können.

10. Vorrichtung nach einem oder mehreren der Ansprüche 6 bis 9, dadurch gekennzeichnet, daß der Innendurchmesser des Vakuumstiftes (9) größer ist, als der Innendurchmesser der Kartuschennadel (8).

## Claims

1. A method for the through plating of holes (5) in multi-layer circuit boards (2), whereby the circuit board (2) is placed on an accepting fixture (3), which leaves the area below the holes (5) free and conducting paste (10) is applied into the holes (5) in the circuit board (2) using a dosing arrangement (8,9) and forming a peripheral coating (12) so that an outstanding expanding pin (11) forms on the reverse side of the hole (5), characterised in that a cartridge needle (8) of the dosing arrangement (8, 9) is positioned on the circuit board (2) in the region of the each hole (5) to be plated through, and solderable conducting paste (10) is introduced, that the cartridge needle (8) is removed and a vacuum pipe (9) of the dosing arrangement (8,9) is placed onto the circuit board (2) in the region of the hole (5) and the conducting paste is partly sucked up, in such a manner that the conducting paste (10) forms contacting peripheral coatings (12, 13) on both sides of the circuit board (2) and a distribution of conducting paste (10) occurs on the internal walls of the holes (5) forming defined least hole diameters.

2. A method according to Claim 1, characterised in that the cartridge needle (8) and the vacuum pipe (9) are arranged on a boring machine head (14) and that the through plating of the holes (5) is effected directly following the mechanical processing of the circuit board (2) using a single device (boring machine head 14).

3. A method according to Claims 1 and 2, characterised in that the function and the working movement of the boring machine head (14) are controlled by a computer (19) and for the through plating a pressure and suction actuation of the cartridge needle (8) and the vacuum pipe (9) are controlled by a control unit (18) depending on the current position of the boring machine head (14) and the data in the computer (19).

4. A method according to one or more of the Claims 1 to 3, characterised in that after the introduction of the conducting paste (10) into a hole (5) a light vacuum is applied to the cartridge needle (8), in such a manner that no further conducting paste (10) emerges.

5. A method according to one or more of the Claims 1 to 4, characterised in that the vacuum pipe (9) is already actuated with suction air during its approach to the individual hole (5) of the circuit board (2) to be plated through, i.e. before setting down, in such a manner that the effect of the suction air is introduced very softly.

6. An arrangement for a method according to Claim 1, characterised in that an accepting fixture (1) with an accepting frame (3) for the circuit board (2) and a dosing arrangement (8, 9) with a cartridge needle (8) is provided, which can be positioned above the holes (5) and set down on the circuit board (2) and by means of which the solderable conducting paste (10) is then introduced into the holes (5), and that the dosing arrangement (8, 9) also has a vacuum pipe (9), which after the introduction of the conducting paste (10) can be set down in the region of the holes (5) and via which the conducting paste (10) is partly sucked up again by means of volume controlled suction air.

7. An arrangement according to Claim 6, characterised in that the cartridge needle (8) and the vacuum pipe (9) of the dosing arrangement (8, 9) are arranged on a boring machine head (14), such that the mechanical processing of the circuit board (2) and the plating through of the holes (5) are effected by a single arrangement (boring machine head 14).

8. An arrangement according to Claims 6 and 7, characterised in that a computer (19) and a control unit (18) are arranged, whereby via the computer (19) the function and the working movement of the boring machine head (14) are controlled, and from the control unit (18) the pressure-, suction activation of the cartridge needle (8) and the vacuum pipe (9) are controlled depending on the current position of the boring machine head (14) and the data in the computer (19), for the through plating.

9. An arrangement according to one or more of the Claims 6 to 8, characterised in that the internal diameter of the cartridge needle (8) at its exit is at least 0.2 mm larger than the diameter of the holes (5) in the circuit board (2), such that in this region contacting peripheral coatings (12) can be formed on the upper side of the circuit board (2).

10. An arrangement according to one or more of the Claims 6 to 9, characterised in that the internal diameter of the vacuum pipe (9) is larger than the internal diameter of the cartridge needle (8).

## Revendications

1. Procédé pour métalliser des trous (5) dans des cartes de circuits imprimés (2) multicouches, la carte de circuits imprimés (2) étant placée sur un cadre de logement (3) qui laisse libre la zone en dessous des trous (5) et de la pâte conductrice (10) étant amenée au moyen d'un dispositif doseur (8, 9) dans les trous (5) de la carte de circuits imprimés (2) en formant des bords de recouvrement (12) de telle sorte qu'il se forme sur l'arrière des trous (5) un tenon (11) dépassant et s'élargissant, **caractérisé en ce qu'**on place une aiguille à cartouche (8) du dispositif doseur (8, 9) sur la carte de circuits imprimés (2) dans la zone de chaque trou (5) à métalliser et en ce qu'on amène de la pâte conductrice (10) pouvant être brasée, en ce qu'on éloigne l'aiguille à cartouche (8), en ce qu'on place une tige à vide (9) du dispositif doseur (8, 9) sur la carte de circuits imprimés (2) dans la zone du trou (5) et en ce qu'on aspire partiellement la pâte conductrice (10) de telle sorte que la pâte conductrice (10) forme dans la zone des trous (5) des deux côtés de la carte de circuits imprimés (2) des bords de recouvrement (12, 13) établissant un contact et qu'il se produit une répartition de la pâte conductrice (10) sur les parois internes des trous (5) avec formation de diamètres de trous minimaux déterminés.

2. Procédé selon la revendication 1, caractérisé en ce que l'aiguille à cartouche (8) et la tige à vide (9) sont associées à une tête de perçage et de fraisage (14) et en ce que la métallisation des trous (5) s'effectue directement après l'usinage mécanique de la carte de circuits imprimés (2) au moyen d'un seul dispositif (tête de perçage et de fraisage 14).

3. Procédé selon les revendications 1 et 2, caractérisé en ce que le fonctionnement et le mouvement d'usinage de la tête de perçage et de fraisage (14) sont commandés par un ordinateur (19) et en ce que, pour l'établissement du contact, une alimentation en air de pression et d'aspiration de l'aiguille à cartouche (8) et de la tige à vide (9) est commandée par un appareil de commande (18) en fonction de la position respective de la tête de perçage et de fraisage (14) et des données prescrites par l'ordinateur (19).

4. Procédé selon une ou plusieurs des revendications 1 à 3, caractérisé en ce que, après l'amenée de la pâte conductrice (10) dans un trou (5), on a un léger vide au niveau de l'aiguille à cartouche (8) de telle sorte qu'il ne sort plus de pâte conductrice (10).

5. Procédé selon une ou plusieurs des revendications 1 à 4, caractérisé en ce que la tige à vide (9) est déjà alimentée en air d'aspiration pendant l'approche du trou (5) respectivement à métalliser sur la carte de circuits imprimés (2), c'est-à-dire avant la mise en place, de telle sorte que l'effet de l'air d'aspiration s'installe avec un dosage très doux.

6. Dispositif pour un procédé selon la revendication 1, caractérisé en ce qu'il est prévu un dispositif de logement (1) avec un cadre de logement (3) pour la carte de circuits imprimés (2) et un dispositif doseur (8, 9) avec une aiguille à cartouche (8) qui peut être positionné au-dessus des trous (5) et être placé sur la carte de circuits imprimés (2) et au moyen duquel la pâte conductrice (10) pouvant être brasée est ensuite amenée dans les trous (5) et en ce que le dispositif doseur (8, 9) comporte en outre une tige à vide (9) qui peut être placée dans la zone des trous (5) après l'amenée de la pâte conductrice (10) et par l'intermédiaire de laquelle la pâte conductrice (10) peut être partiellement réaspirée au moyen d'air d'aspiration à dosage commandé.

7. Dispositif selon la revendication 6, caractérisé en ce que l'aiguille à cartouche (8) et la tige à vide (9) du dispositif doseur (8, 9) sont agencées sur une tête de perçage et de fraisage (14) de telle sorte que l'usinage mécanique de la carte de circuits imprimés (2) et la métallisation des trous (5) s'effectue au moyen d'un seul dispositif (tête de perçage et de fraisage 14).

8. Dispositif selon les revendications 6 et 7, caractérisé en ce qu'il est prévu un ordinateur (19) et un appareil de commande (14), le fonctionnement et le mouvement d'usinage de la tête de perçage et de fraisage (14) étant commandés par l'intermédiaire de l'ordinateur (19) et, pour l'établissement du contact, une alimentation en air de pression et d'aspiration de l'aiguille à cartouche (8) et de la tige à vide (9) étant commandée par l'appareil de commande (14) en fonction de la position respective de la tête de perçage et de fraisage (14) et des données prescrites par l'ordinateur (19).

9. Dispositif selon une ou plusieurs des revendications 6 à 8, caractérisé en ce que le diamètre intérieur de l'aiguille à cartouche (8) dans sa zone de sortie est au moins plus grand de 0,2 mm que le diamètre des trous (5) de la carte de circuits imprimés (2) de telle sorte que, dans cette zone, les bords de recouvrement (12) à métalliser peuvent être formés sur le dessus de la carte de circuits imprimés (2).

10. Dispositif selon une ou plusieurs des revendications 6 à 9, caractérisé en ce que le diamètre intérieur de la tige à vide (9) est plus grand que le diamètre intérieur de l'aiguille à cartouche (8).
